# EUROPEAN PATENT APPLICATION

(11) **EP 3 789 918 A1**
(43) Date of publication of application: **10.03.2021**
(21) Application number: 19196030.1
(22) Date of filing: 06.09.2019
(51) Int. Cl.: G06K 19/077, H05K 1/09, H01Q 1/38

(54) **CARBON-BASED ANTENNAS**

(71) Applicant: Advanced Material Development Limited, Brighton, East Sussex BN1 9SB (GB)
(72) Inventor: The designation of the inventor has not yet been filed
(74) Representative: Bajjon, Alexander

(57) **Abstract**

The invention provides RFID antennas comprising nanoparticulate graphite (NPG) and having a shape comprising a central inductive loop region comprising one or more inductive loops and two capacitance pads at opposing sides of the inductive loop region. One antenna of the invention comprising nanoparticulate graphite (NPG) having a resonant frequency of from 0.86GHz to 0.96GHz and a footprint of 3200mm² or less and optionally:
(i) a range of greater than 4m, for example greater than 6m, preferably greater than 8m; and/or
(ii) a return loss (when measured at 0.91 GHz) of-5dB or greater; and/or
(iii) a Q-value of from 5 to 20, for example from 5 to 15, preferably from 8 to 11; and/or
(iv) a sheet resistance of 5Ω/sq or less, for example 2Ω/sq or less, preferably 1Ω/sq or less; and/or
(v) a VSMR of 2 or less, for example 1.7 or less, preferably 1.5 or less.

## Description

### Introduction

This present invention relates to carbon-based antennas for use in RFID systems and methods of making such antennas.

### Background to the Invention

RFID (radio frequency identification) systems use electromagnetic fields to automatically identify objects. The systems typically comprise a plurality of RFID tags (each comprising a microchip and an antenna) and one or more RFID readers. The RFID reader generates a magnetic field which induces an electric current in the antenna of the RFID tag. The current is sent to the microchip in the tag and, in a passive RFIF tag, power harvested from the electric current induced in the antenna is used to activate the microchip. Once activated, the tag sends a radio wave back to the reader, with the frequency of the returned radio wave modulated to encode specific information (e.g. a specific identifier for the tag or the object to which the tag is attached). The reader then receives this radio wave and the reader can decode the information modulated within the radio wave. The decoded information is then typically communicated to a computer system which processes the information depending on its application.

The range over which the interaction between the RFID tags and readers can occur is dependent on the resonant frequency of the antenna. For short-range applications (referred to as near-field communication - NFC), frequencies between 100 kHz and 20 MHz are used and allow for a reader to detect a tag at a distance of up to approximately 10 cm. Such technology is used in the application of "contactless" card payments.

For longer-range applications, higher frequencies (ultra-high frequencies - UHF) are used, typically between 860 and 960 MHz. This can provide interaction ranges of up to approximately 10m.

RFID systems have already been used in a wide variety of applications including in systems for tracking products, persons/animals and materials. For example, RFID systems have been used for logistics and supply chain visibility and inventory tracking.

Currently, RFID tag antennas are typically made from metals, such as aluminium. However, from an environmental perspective there is a growing need to reduce the metal content of the antennas to be used in RFID tags.

While carbon-based (e.g. graphene-based) RFID antennas are known, they are typically larger than the corresponding metal antennas (owing to their higher resistivity). The size of the carbon-based antennas limits their applications.

There therefore exists the need for alternative, preferably improved antennas, for example smaller, metal-free antennas that can be used in RFID applications.

### The Invention

The inventors of the present application have designed unique, metal-free antennas that can be used in RFID applications.

Accordingly, the invention provides an RFID antenna comprising nanoparticulate graphite (NPG) and having a shape comprising:
a) a central inductive loop region comprising one or more inductive loops; and
b) two capacitance pads at opposing sides of the inductive loop region.

As per other types of antennas, RFID antennas are capable of both converting electromagnetic waves (more specifically the magnetic field component of electromagnetic waves) into an electrical current via induction and also converting an electrical current into electromagnetic waves. In other words, the antennas can both receive and transmit.

In use, opposite and alternating charges on the two planar capacitance pads generate an electric field that propagates in a direction perpendicular to the pads, when an electrical current is passed through the antenna.

The antennas comprise nanoparticulate graphite particles (NPG). The particles of the NPG typically have diameters (mass median diameters - MMD) of less than 150nm, for example less than 100nm, in size (measured conventionally, e.g. using laser diffraction methods). In addition, in contrast to smaller graphene nanoparticles, NPG typically has a layer number of greater than 5, for example greater than 10. NPG is usually distinguished from graphite in than it has a layer number of 200 or less, for example 150 or less, preferably 100 or less.

The NPG-containing antennas of the invention typically have a film conductivity of 10,000 S/m or greater, for example 25,000 S/m or greater, preferably 40,000 S/m or greater. As discussed below, the antennas can be formed by depositing multiple layers of NPG onto a substrate and subsequently calendaring the deposited layers to increase their density and conductivity. For complete clarity, the film conductivities provided above are the film conductivities of the antenna materials after any calendaring process has taken place.

NPG can be obtained by the exfoliation of graphite. Numerous methods of exfoliating graphite to produce graphite-based nanoparticles are known to those skilled in the art and include sonication with ultrasound and liquid jet milling. A further example a method for exfoliating graphite is described in European patent application no. 18200075.2.

Graphite exfoliation processes typically result in a mixture of graphite-based or graphite-derived particles, such as: (i) unexfoliated graphite starting material; (ii) graphene nanoplatelets; and (iii) intermediate sized, nanoparticulate graphite particles (NPG). NPG can be extracted from the output of graphite exfoliation processes by numerous separation techniques, such as centrifugation.

Typically, the antennas comprise 60% or more, 75% or more or 85% or more, preferably 90% or more or 95% or more (by weight) NPG. For example, the antennas of the invention may consist essentially of NPG (e.g. comprise 99% or more of NPG (by weight)). The antennas are preferably "metal-free" antennas in that they contain substantially no (or less than 1%, preferably less than 0.1% by weight of) metal. As discussed below, the antennas may be supported by a substrate (e.g. a plastics or polymeric substrate), and may be connected to circuitry (such as a microchip). The weight ranges provided above refer to the antenna itself, excluding any such support material or circuitry.

It may be desirable to add a binder to the NPG to prevent blistering and delamination of the antennas. The binder may be chosen such that it does not affect the sheet conductivity of the antenna. For example, gelatine can be added (in a weight range of up to 5% by weight relative to the NPG weight) without substantially affecting the conductivity of the antenna.

Alternatively or additionally, a component may be added to increase the conductivity of the antenna. For example, carbon nanoparticles (such as carbon nanotubes) can be added (e.g. in an amount of up to 25%, or up to 20% by weight relative to the NPG weight).

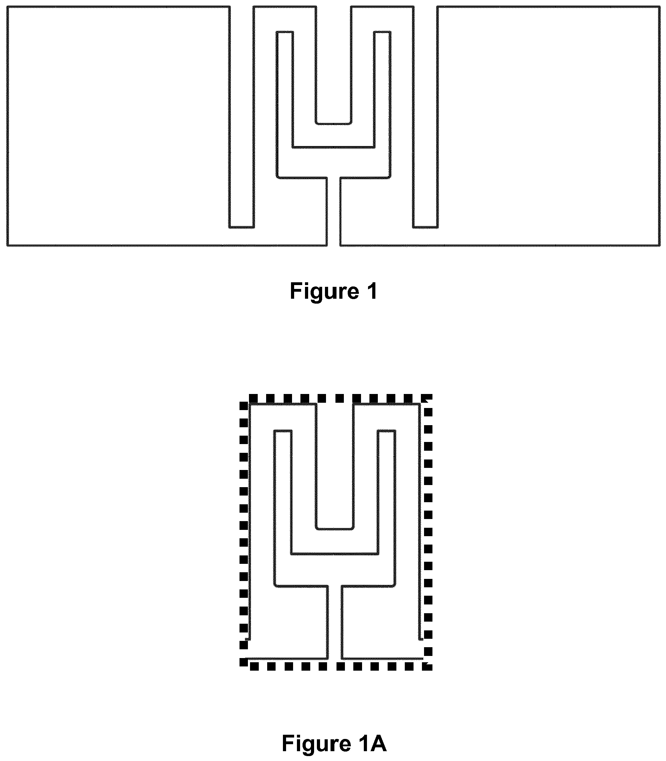

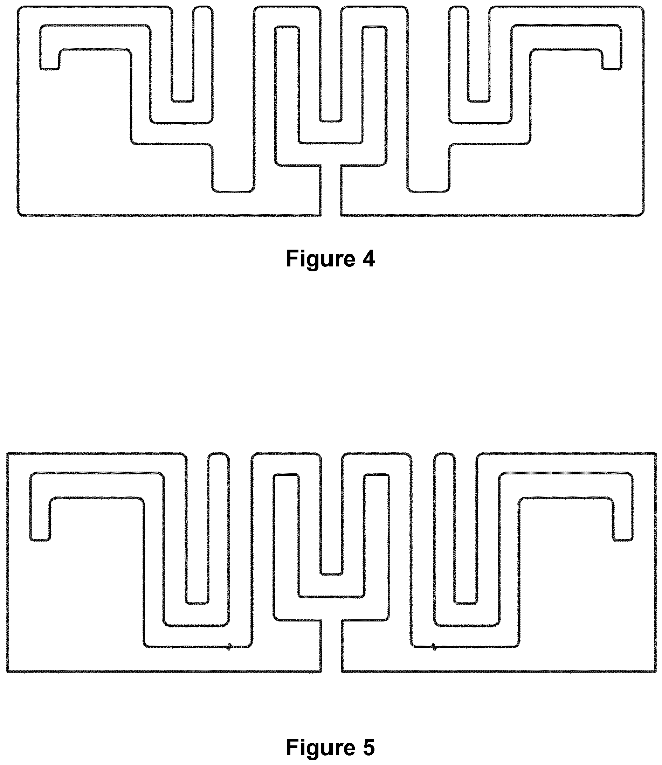

Example antenna shapes are shown in Figures 1 to 5.

The antennas are preferably planar in shape. However, due to the low thickness and high flexibility of the antennas, the planar antennas can be applied to curved or rounded surfaces without substantially affecting their properties. The antennas can be supported by flexible materials which assist in maintaining the antennas' integrity while allowing flexing during use.

As discussed above, the antennas comprise an inductive loop region comprising one or more inductive loops and two capacitance pads. The inductive loop or loops are shaped such that an electric current is induced within the antenna when subject to the magnetic field of an electromagnetic radio wave. The capacitance pads are shaped such that an electric current within the antenna can be used to generate an electromagnetic radio wave (which can then be received and detected by an RFID reader).

The antennas comprise one or more inductive loops at a central inductive loop region of the antenna. The inductive loop region of the antenna comprises a serpentine path or track of the antenna material between the two capacitance pads. There is thus a continuous conductive path from a first capacitance pad on one side of the antenna to a second capacitance pad on the other side. Typically, the width of the path is from 1mm to 4mm, preferably from 2mm to 3mm.

The inductive loop or loops may be formed by a path reversing back on itself to form a U-shaped bend or a Ω shaped bend. Referring to the Figures, preferred loops have paths that reverse back on themselves to increase the overall path length within the footprint of the antenna. The overall path length in the central inductive loop region is therefore generally greater than the circumference of a square or rectangle that fits the loop exactly (see Figure 1A, where the dotted line indicates the circumference of the rectangle that fits the loop exactly and it can be seen that the overall path length in the central inductive loop region exceeds this length). The circumference of such a rectangle would be limited to the total length along the four sides; the length of the central inductive loop is greater than this circumference because its loop extends into and out of the imagined rectangle.

The antennas may have a single central loop region (see Figure 1 as just one example). The central loop region may comprise numerous loops (see Figures 2 and 3). Alternatively, the antennas may have a central loop region located between the two capacitance pads along with one or more further "outer loops" connected to each capacitance pad. Examples of such antenna can be seen in Figures 4 and 5. The term "outer" as used in this context refers to the order along the track of the antenna of the various components from the central loop region outwards and to components distal to the center of the antenna.

Hence, antennas can be arranged:
(i) pad - central loop - pad;
(ii) pad - loop - central loop - loop - pad; or
(iii) outer loop - pad - central loop - pad - outer loop.

Preferably, where the antenna comprises at least two inductive loops within the central loop region, the two of the loops are arranged together provide a "tuning-fork" configuration (the shape of which is shown in Figures 1 to 5).

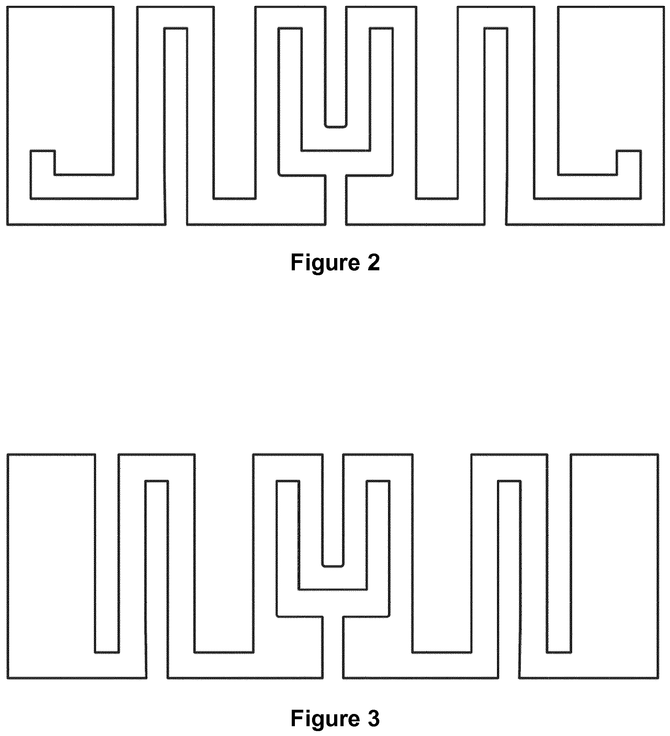

At each end of the central inductive portion of the antenna is a capacitance pad. The capacitance pads are typically substantially square or substantially rectangular. It is noted that the terms "substantially square" and "substantially rectangular" cover square or rectangular shapes in which the corners have been rounded. Although the capacitance pads may be substantially square or substantially rectangular, the shape may be modified such that small amounts of material are added or cut away from the overall square or rectangular shape of the capacitance pads (as shown in Figures 2, 5 and 6). Such shapes are encompassed by the terms "substantially square" and "substantially rectangular".

The area of each capacitance pad will depend on the overall footprint of the antenna and the size of the inductive region, but will typically be from 100mm² to 400mm², for example from 150mm² to 300mm².

The shape and design of the antennas of the invention allows for a smaller NPG-based antenna with a resonant frequency of approximately 0.86GHz to 0.96GHz compared to conventional antenna with the same resonant frequency. The footprint of the antenna may be 3200mm² or less, for example 2500mm² or less, typically 2100mm² or less, preferably 1900mm² or less. The term "footprint" as used herein refers to the area of the smallest rectangle (or square) in which the antenna can be placed (without exceeding the size of the rectangle or square).

Typically the antenna are configured to receive and transmit radio waves at ultra-high frequencies (UHF), for example between frequencies of 0.86GHz and 0.96GHz, which allows for long range (e.g. up to 10m) interactions between the RFID tag and the RFID reader. As shown in the examples below, the invention provides an antenna for an RFID tag which has a resonant frequency of about 0.91 GHz and preferably the antennas of the invention have a resonant frequency of 0.91 GHz.

The antennas typically have a range of greater than 4m, for example greater than 6m, preferably greater than 8m. Ranges of the antenna can be measured using commercially available UHF RFID readers at a transmitter power of 30 dBm and a read sensitivity of - 60 dBm.

The range of the antennas increases with the return loss of the antenna (at the desired frequency). Accordingly, the antennas typically have a return loss (when measured at 0.91 GHz) of -5dB or greater, for example -7.5dB or greater, preferably -10dB or greater. The term "greater" when used in the context of return loss values indicates a more negative number. The return loss of the antennas can be measured using a Vector Network Analyser.

The Q-value of an antenna is a measure of its bandwidth. The Q-value is defined as f_{c}/Δf wherein f_{c} is the central frequency (i.e. the resonant frequency) and Δf is the bandwidth. f_{c} and Δf can be measured using a Vector Network Analyser. Generally, a smaller bandwidth (and a correspondingly higher Q-value) is desirable to maximise the signal strength at the frequency of interest.

However, for RFID tag applications, it may be desirable for the antenna to operate at different frequencies. For example, in Europe standard RFID tag readers operate at a frequency of 0.86GHz while in the US, RFID tag readers operate at a frequency of approximately 0.91GHz (see https://rfid4u.com/rfid-basics-resources/basics-rfid-regulations/). Therefore, the antennas of the present invention preferably have a sufficient bandwidth to provide sufficient signal strengths at both of these frequencies.

For example, the antennas of the invention may have a Q value of from 5 to 20, for example from 5 to 15, preferably from 8 to 11.

The sheet resistance of the antennas also affects their performance and range. A lower sheet resistance generally results in an increased antenna range. The antennas of the invention typically have a sheet resistance of 5Ω/sq or less, for example 2Ω/sq or less, preferably 1Ω/sq or less. Sheet resistances can be measured by a transmission line method on square films having sizes of at least 2cm by 2cm.

A further measure of the efficiency of an antenna is the Voltage Standing Wave Ratio (VSWR). The VSWR is defined as the ratio of the maximum to minimum voltage on a loss-less line. The VSWR is usually expressed as a ratio, e.g. 2:1, 5:1. The antennas of the invention typically have a VSWR of 2:1 or less, for example 1.7:1 or less, preferably 1.5:1 or less. The VSWR of the antenna can be measured using a Vector Network Analyser.

The inventors of the present application have found that nanoparticulate graphite can be used to produce antennas with one or more or all of these properties. In particular, the inventors have shown that NPG-based antennas can be produced with smaller footprints than conventional carbon-based antennas. For example, as described above, the footprint of the antenna may be 3200mm² or less, typically 2500mm² or less, or preferably 1900mm² or less.

Accordingly, the invention also provides an antenna comprising nanoparticulate graphite having a resonant frequency of from 0.86GHz to 0.96 GHz (for example, 0.91GHz) and a footprint of 3200mm² or less and optionally:
(i) a range of greater than 4m, for example greater than 6m, preferably greater than 8m; and/or
(ii) a return loss (when measured at 0.91GHz) of -5dB or greater; and/or
(iii) a Q-value of from 5 to 20, for example from 5 to 15, preferably from 8 to 11; and/or
(iv) a sheet resistance of 5Ω/sq or less, for example 2Ω/sq or less, preferably 1Ω/sq or less; and/or
(v) a VSWR of 2:1 or less, for example 1.7:1 or less, preferably 1.5:1 or less

Antennas of particular embodiments comprise nanoparticulate graphite and have a resonant frequency of from 0.86GHz to 0.96 GHz and a footprint of 3200mm² or less and:
(i) a range of greater than 4m;
(ii) a return loss (when measured at 0.91GHz) of -5dB or greater;
(iii) a Q-value of from 8 to 11;
(iv) a sheet resistance of 2Ω/sq or less; and
(v) a VSWR of 1.5:1 or less.

Also provided is an antenna comprising nanoparticulate graphite (optionally as described herein) having a shape substantially as shown in any one of Figures 1 to 5. For example, there is provided an antenna comprising nanoparticulate graphite having a shape substantially as shown in Figure 1.

The antennas are typically formed by mask-spray coating. The antennas typically have thicknesses of 2µm or greater, for example 5µm or greater. Typically, the thicknesses of the antennas are 20µm or less, for example 15µm or less, preferably 10µm or less. The antennas may therefore have a thickness of from 2µm to 20µm, for example from 5µm to 10µm. The antennas are generally printed onto a substrate suitable for incorporation into end products.

Typically, the substrate is a polymeric substrate, such as a plastics material. The plastics material may have a dielectric constant (at 1MHz) of from 2 to 4, for example from 2.5 to 3.5. Examples of suitable polymeric substrates are those formed from polyethylene terephthalate (PET) (e.g. Mylar®), polyamide or polyimide (e.g. Kapton®). Alternatively, the substrate may be a paper-based substrate and may optionally be coated with a polymeric coating (such as a PET, polyamide or polyimide coating).

Alternatively, the antenna may be formed by a printing process. Examples of such printing processes include to inkjet, gravure and flexographic printing. However, for these processes, the thicknesses of the antennas are typically limited to thicknesses of up to 1 µm. However, greater antenna thicknesses can be achieved using a multi-pass approach which involves printing layers of the NPG material on top of each other. Where a multi-pass approach is used, the final antenna is typically compressed (e.g. calendared) to improve the density, strength and conductivity of the antenna.

The invention is now illustrated in specific examples.

### Brief Description of the Drawings

Figure 1 shows the shape of an antenna according to the invention.
Figure 1A shows the central inductive loop region of the antenna of Figure 1 with the circumference of the rectangle that fits the loop exactly indicated.
Figures 2 to 5 shows the shapes of further antennas according to the invention.

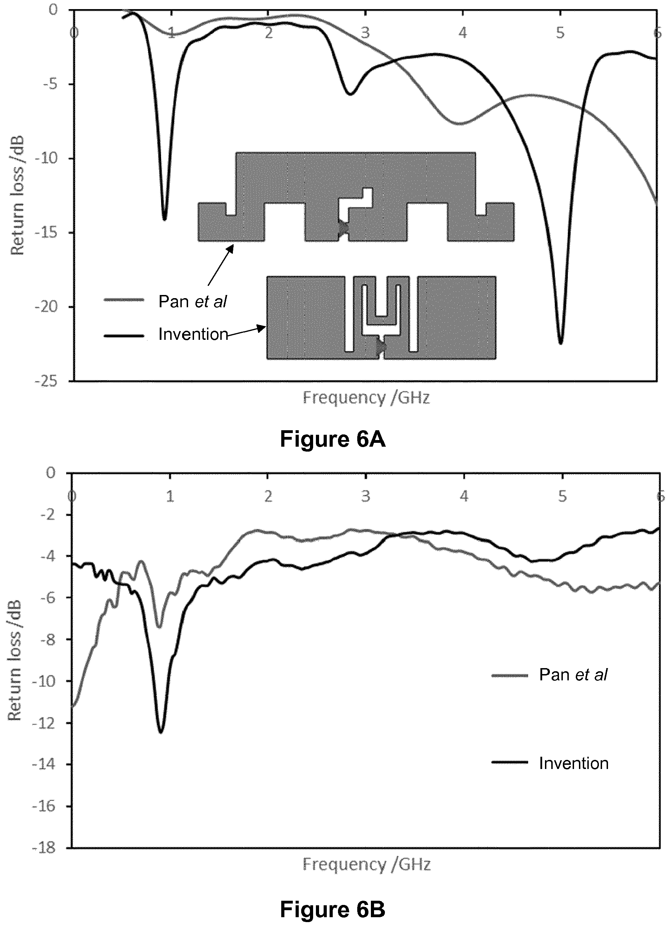

Figure 6A shows simulated responses of an antenna of the invention with an antenna having the shape described in Pan *et al* (as described below).
Figure 6B shows experimental responses of an antenna of the invention with an antenna having the shape described in Pan *et al* (as described below).

### Detailed Description of the Invention

### Antenna Production Process

An antenna having the shape shown in Figure 1 was prepared using a mask-spray process.

A self-adhesive mask was prepared corresponding to the shape of the antenna shown in Figure 1 and attached to a polyethylene terephthalate substrate. The footprint of the antenna was 88mm x 36mm.

Materials were prepared in the form of an aqueous NPG paste at high solid loading (∼30wt%). An aqueous graphite dispersion which has been subjected to an exfoliation process was obtained. The exfoliation process may be a sonication process, a liquid jet milling process, or a process as described in European patent application no. 18200075.2.

The dispersion was then centrifuged at a 200G for 20 minutes in a Beckman Coulter Avanti J-15R centrifuge to separate exfoliated graphite (i.e. graphene) and partially exfoliated graphite (e.g. NPG) from unexfoliated graphite. The resultant graphene and NPG dispersion was then further centrifuged at 5000G for 20 minutes to yield a few-layer graphene supernatant dispersion and an NPG sediment paste (which had a solid content of approximately 30% w/w, with respect to the water remaining in the paste).

This paste was diluted down to an approximately viable printing consistency by mixing a 1:1 ratio of the NPG paste and ethylene glycol.

Spraying on a 43T mesh was performed, followed by drying on a hotplate at 110°C for ∼2 minutes, and finally calendaring/compression to give an antenna with a final thickness of 7µm.

The resulting printed film has a sheet resistance of <2 Ohm/sq, and a conductivity of 50,000 S/m.

The adhesive mask was removed and an Alien Higgs3 chip was attached and the properties of the antenna were determined with an Impinj Speedway Revolution R120 fixed RFID reader.

The antenna was found to have a resonant frequency of 0.91GHz and a range of 2-3m.

A number of other properties of the antenna were measured using a Vector Network Analyser:

| **Property** | **Value** |
|---|---|
| Voltage Standing Wave Ratio (VSWR) | 1.6 |
| Q-value | 11.4 |
| Return Loss | -12 |

The properties of the antenna described above (and shown in Figure 1) were compared with a known graphene antenna described in Pan et al ("Sustainable production of highly conductive multilayer graphene ink for wireless connectivity and loT applications", Nature Comms, 2018, 9:5197.)

Simulations of the antenna properties were performed and compared with experimentally measured properties of the antenna of the invention and a comparison antenna having the shape described in Pan et al and the same sheet resistance as the antenna prepared as described above.

The results are compared in the Figures 6A and 6B.

The primary point of note is significantly better performance of the current design, in both the simulations and experimental measurements. The return loss at the 0.91 GHz resonance in the present design is significantly lower than in the Pan *et al* design, which also leads to a lower VSWR (1.6 vs 2.5) indicating superior antenna performance.

Also of interest is that the reported sheet resistance of the published realisation for the Pan *et al* design is 2.77 Ohm/sq; significantly higher than that the antenna of the invention (∼1 Ohm/sq).

Accordingly, the invention provides carbon-based antennas for use in RFID systems.

## Claims

1. An RFID antenna comprising nanoparticulate graphite (NPG) and having a shape comprising:
a) a central inductive loop region comprising one or more inductive loops; and
b) two capacitance pads at opposing sides of the inductive loop region.

2. An antenna according to claim 1 which is planar in shape.

3. An antenna according to claim 1 or claim 2 where the antenna comprises two or more inductive loops.

4. An antenna according to any one of claims 1 to 3 wherein the inductive loop region of the antenna is formed by a serpentine path of the antenna material.

5. An antenna according to claim 4 wherein the width of the serpentine path is from 2mm to 4mm.

6. An antenna according to claim 4 or 5 wherein the inductive loop(s) is/are formed by the serpentine paths reversing back on themselves to form a substantially U-shaped bend.

7. An antenna according to any one of claims 1 to 6 wherein each capacitance pad is substantially square or substantially rectangular in shape and has an area of from 100mm² to 400mm².

8. An antenna comprising nanoparticulate graphite (NPG) having a resonant frequency of from 0.86GHz to 0.96GHz and a footprint of 3200mm² or less and optionally:
(i) a range of greater than 4m, for example greater than 6m, preferably greater than 8m; and/or
(ii) a return loss (when measured at 0.91GHz) of -5dB or greater; and/or
(iii) a Q-value of from 5 to 20, for example from 5 to 15, preferably from 8 to 11; and/or
(iv) a sheet resistance of 5Ω/sq or less, for example 2Ω/sq or less, preferably 1Ω/sq or less; and/or
(v) a VSMR of 2 or less, for example 1.7 or less, preferably 1.5 or less.

9. An antenna comprising nanoparticulate graphite having a shape substantially as shown in any one of Figures 1 to 5.

10. An antenna according to claim 8 having a shape substantially as shown in any one of Figures 1 to 5.

11. An antenna according to any one of claims 1 to 10 having a footprint of 3200mm² or less.

12. An antenna according to any one of claims 1 to 11 wherein the MMD of the NPG is less than 150nm in size and/or has a layer number of greater than 10.

13. An antenna according to any one of claims 1 to 12 having a film conductivity of 10,000 S/m or greater.

14. An antenna according to any one of claims 1 to 13 wherein the antenna comprises 75% or more by weight of NPG.

15. An antenna according to any one of claims 1 to 14 having a thickness of from 5µm to 10µm.
